# FASCICULE DE BREVET EUROPEEN

(11) **EP 0 568 524 B1**
(45) Date de publication et mention de la délivrance du brevet: **08.03.1995**
(21) Numéro de dépôt: 89912633.8
(22) Date de dépôt: 02.11.1989
(51) Int. Cl.: H01M 4/58, C03C 3/12, C23C 14/06, H01M 6/18

(54) **ELEMENT COMPOSITE COMPORTANT UNE COUCHE EN CHALCOGENURE OU OXYCHALCOGENURE DE TITANE, UTILISABLE EN PARTICULIER COMME ELECTRODE POSITIVE DANS UNE CELLULE ELECTROCHIMIQUE EN COUCHES MINCES**
SCHICHTSTOFF, ENTHALTEND EINE TITANCHALKOGEN- ODER -OXICHALKOGENSCHICHT, INSBESONDERE ZUR VERWENDUNG ALS POSITIVE ELEKTRODE IN EINER DÜNNSCHICHT-BRENNSTOFFZELLE
COMPOSITE ELEMENT COMPRISING A TITANIUM CHALCOGEN OR OXYCHALCOGEN LAYER, SUITABLE IN PARTICULAR FOR USE AS A POSITIVE ELECTRODE IN A THIN-LAYER FUEL CELL

(30) Priorité: 04.11.1988 FR 8814435
(43) Date de publication de la demande: 10.11.1993
(73) Titulaire: CENTRE NATIONAL DE LA RECHERCHE SCIENTIFIQUE (CNRS), 75016 Paris (FR)
(72) Inventeur: MEUNIER, Georges, F-33650 Labrede (FR); DORMOY, Richard, F-33170 Gradignan (FR); LEVASSEUR, Alain, F-33170 Gradignan (FR)
(74) Mandataire: Des Termes, Monique
(86) Numéro de dépôt international: FR8900568
(87) Numéro de publication internationale: WO9005387

(56) Documents cités:
- EP-A- 0 010 070
- EP-A- 0 201 422
- US-A- 4 508 608
- Chemical Abstracts, vol.111, No. 16, 16 October 1989, (Columbus, Ohio, US), G. Meunier et al.: "New positive-electrode materials for lithium thin film secondary batteries", see page 200, abstract 13748r, & Mater. Sci. Eng., B 1989, B3(1-2), 19-23
- Crystal Research and Technology, vol. 23, No. 4, April 1988, (Berlin, DE), K.S. Chandra Babu et al.: "Photo-electrochemical solar cells based on TiS2/TiO2(TiOxSy) photoelectrodes" pages 555-560, see the whole article
- Applied Surface Science, vol. 33/34, September 1988, Elsevier Science Publishers B.V., (North-Holland Physics Publishing Division), (Amsterdam, NL),. C. Kaito et al.: "Studies of the structure and the crystallization process of ion sputtered TiSe2 films", pages 509-515, see the whole article
- Journal of Power Sources, vol. 7, No. 1, November 1981, Elsevier Sequoia S.A. (Lausanne, CH), K.M. Abraham: "Status of rechargeable positive electrodes for ambient temperature batteries", pages 1-43

## Description

La présente invention a pour objet un élément composite comportant une couche en chalcogénure ou oxychalcogénure de titane, utilisable en particulier comme électrode positive dans une cellule électrochimique en couches minces, telle qu'un générateur électrochimique ou une cellule électrochrome.

De façon plus précise, elle concerne la réalisation de cellules électrochimiques à électrodes et électrolyte solides, en particulier de cellules électrochimiques en couches minces dont le principe de fonctionnement est basé sur l'insertion et la désinsertion (ou intercalation - désintercalation) d'un ion de métal alcalin ou d'un proton dans l'électrode positive.

Des cellules électrochimiques de ce type peuvent trouver de nombreuses applications, par exemple sous la forme de microgénérateurs ayant une épaisseur totale de quelques micromètres, dans des systèmes pour sauvegarder les mémoires de microsystèmes lors de coupures de courant ou comme systèmes intégrés dans des cartes à mémoire du type des cartes bancaires.

Ces cellules électrochimiques peuvent aussi être utilisées comme système électrochrome lorsque l'électrode positive change de couleur au cours de L'insertion, ce qui les rend intéressantes pour l'affichage d'informations ou mieux encore, lorsque l'électrode négative est transparente, pour des vitrages changeant de couleur selon les besoins (smart windows).

On connaît différents modes de réalisation de cellules électrochimiques "tout solide" éventuellement en couches minces, à électrodes et électrolyte solides. Ainsi, le brevet français FR-A- 2 581 483 décrit une pile solide comprenant successivement une couche d'un métal alcalin tel que le lithium, constituant une source d'ions, une couche d'électrolyte solide conducteur ionique et une couche de composé lamellaire d'intercalation susceptible de recevoir et d'accumuler des ions issus de ladite couche de métal alcalin. Le composé lamellaire peut être une substance de formule MX₂, par exemple TiS₂, et il peut être déposé par épitaxie.

Le brevet français FR-A- 2 550 015 décrit lui aussi un générateur électrochimique "tout solide" constitué d'une électrode positive en un composé d'insertion du lithium tel que TiS₂ cristallisé, un électrolyte conducteur ionique par ions Li+ et une électrode négative en lithium.

Le brevet européen EP-A- 0127373 décrit une batterie en couche mince comportant une électrode positive en TiS₂ cristallisé déposée sur un collecteur de courant avec une couche intermédiaire de TiO₂ amorphe, un électrolyte en verre conducteur ionique et une électrode négative en lithium.

On a aussi envisagé de réaliser des générateurs comportant des électrodes positives massives en chalcogénure de métal de transition amorphe par des procédés chimiques comme il est décrit dans US-A-4 299 892 et WO-88/00172.

Dans le cas des électrodes positives en TiS₂ cristallisé, l'insertion et la désinsertion du lithium sont rendues plus difficiles en raison du caractère anisotrope de l'électrode. De plus, ces électrodes résistent mal aux insertions-désinsertions et ont une stabilité insuffisante.

Dans le cas des électrodes positives amorphes préparées par voie chimique, le mode de préparation de l'électrode ne se prête pas à la réalisation de couches minces.

Les générateurs "tout solide" ne donnent pas entière satisfaction car les densités de courant que l'on peut obtenir restent inférieures a 20»A/cm². En outre, l'utilisation d'un électrolyte solide avec des électrodes amorphes pose certains problèmes car ces électrolytes ne sont pas de très bons conducteurs ioniques. De ce fait, les performances du générateur sont limitées, car l'état de surface des électrodes ne permet pas d'utiliser une épaisseur d'électrolyte solide inférieure à 20»m, pour éviter tout risque de contact direct entre l'électrode positive et l'électrode négative.

La présente invention a précisément pour objet un élément composite utilisable comme électrode positive, en particulier en couche mince, dans une cellule électrochimique du type "tout solide", qui permet d'obtenir de meilleurs résultats et de pallier les inconvénients décrits ci-dessus.

L'élément composite selon l'invention est constitué par un substrat revêtu par pulvérisation cathodique d'une couche de matériau amorphe aux rayons X et isotrope répondant à la formule :

TiOₐX_{b}

dans laquelle X représente un atome de soufre, de sélénium ou de tellure, et
a et b sont tels que
0,01 ≦ a ≦ 2
0,01 ≦ b ≦ 3
2 ≦ a + b ≦ 3
ladite couche ayant une épaisseur de 200nm à 10 »m, une structure amorphe expansée et un profil extrêmement régulier sans porosité superficielle.

Généralement X représente un atome de soufre.

Dans ce cas, le matériau isotrope est du type oxysulfure de titane.

L'élément composite de l'invention comprend ainsi :
- un substrat, de préférence conducteur, et
- une couche de TiOₐX_{b} qui sont indissociables l'un de l'autre du fait du procédé de préparation par pulvérisation cathodique.

Selon l'invention, grâce au choix d'un matériau du type TiOₐX_{b} et de son mode de dépôt par pulvérisation cathodique, on obtient une couche de matériau isotrope et amorphe de densité beaucoup plus faible que celle de TiO₂ ou TiS₂ cristallisés, qui résiste très bien de ce fait à l'insertion et à la désinsertion d'ions de métal alcalin ou de protons. En effet, cette faible densité correspond à une structure amorphe expansée et il n'y a pas de gonflement du matériau lors de l'insertion des ions. Ainsi, la couche ne se détériore pas car le transport des ions s'effectue sans changement de morphologie. Cette couche isotrope offre également l'avantage de permettre une bonne diffusion du lithium dans toutes les directions.

Un bref passage à l'air de la couche de TiOₐX_{b} peut modifier les valeurs de a et b à la surface de la couche sans altérer pour autant les propriétés électrochimiques de l'élément composite.

Le matériau isotrope de l'invention est donc très intéressant pour une utilisation comme électrode dans une cellule électrochimique du genre "tout solide".

Par ailleurs, il semble que dans ce matériau il n'y ait pas que le titane qui participe à la réaction électrochimique. Ainsi, dans le cas où X représente le soufre, on peut supposer que le soufre est présent dans le matériau à deux états d'oxydation, ce qui permettrait d'obtenir un système réversible à plus basse tension.

De préférence, ce matériau isotrope est un oxysulfure.

Les substrats utilisés dans cet élément composite peuvent être très divers, conducteurs isolants, souples ou rigides. Généralement, on utilise un substrat conducteur de l'électricité ou un substrat mixte comportant un support isolant recouvert d'une couche conductrice de l'électricité sur laquelle est déposée la couche de matériau isotrope TiOₐX_{b}.

La couche conductrice de l'électricité peut être en particulier en métal, par exemple Pt, Ni, Al, etc., en silicium monocristallin ou en oxyde conducteur de l'électricité comme les oxydes mixtes d'indium et d'étain (ITO).

Le support isolant peut être un matériau céramique, du pyrex, un verre ou une matière plastique résistant aux conditions de pulvérisation cathodique, par exemple une matière plastique souple telle qu'un polyester comme le polytéréphtalate d'éthylène glycol, ou un polyimide.

Ces substrats souples permettent en particulier la réalisation en continu d'éléments composites de grande surface car on peut les faire défiler en continu dans l'enceinte de dépôt par pulvérisation cathodique.

L'élément composite de l'invention peut ainsi constituer l'électrode positive d'un générateur électrochimique avec le support d'électrode et/ou le collecteur de courant associé. En fonctionnement, des ions de métal alcalin ou des protons sont insérés dans cette électrode positive en TiOₐX_{b}.

Aussi, l'invention a également pour objet une cellule électrochimique comportant une électrode positive, une électrode négative capable de libérer un proton ou un ion de métal alcalin, et un électrolyte conducteur ionique disposé entre les deux électrodes, caractérisée en ce que l'électrode positive est formée d'une couche mince, composite, continue et homogène de matériau amorphe aux rayons X et isotrope, déposée par pulvérisation cathodique, répondant à la formule :

TiOₐX_{b}

dans laquelle X représente S, Se ou Te et a et b sont tels que
0,01 ≦ a ≦ 2
0,01 ≦ b ≦ 3
2 ≦ a + b ≦ 3
ladite couche ayant une épaisseur de 200nm à 10 »m, une structure amorphe expansée et un profil extrêmement régulier sans porosité superficielle.

Comme précédemment, X représente de préférence S.

En fonctionnement, la composition de la couche TiOₐX_{b} évolue de façon réversible et correspond à la formule :

M_{c}TiOₐX_{b}

dans laquelle M représente un proton ou un ion de métal alcalin, c est tel que 0 ≦ c ≦ 4 et X, a et b ont la signification donnée ci-dessus.

Le fonctionnement de cette cellule électrochimique ne correspond pas seulement aux réactions électrochimiques suivantes :

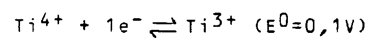

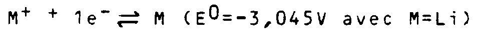

E⁰ représente le potentiel standard par rapport à l'électrode à hydrogène et il est défini dans le cas de solutions.

La réaction globale est dans ce cas : 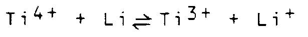
et ceci correspond à une force électromotrice de 2,945V.

Ce schéma est théorique car comme on le verra plus loin, d'une part, l'activité de l'ion M⁺ peut être différente et, d'autre part, d'autres espèces ioniques provenant par exemple du soufre, peuvent participer à la réaction électrochimique.

Avec l'électrode positive décrite ci-dessus, l'électrode négative peut être réalisée en particulier en lithium ou en matériau contenant du lithium. Le matériau contenant du lithium peut être un alliage de lithium ou un composé de lithium.

A titre d'exemples, on peut utiliser des oxydes mixtes de lithium et de métal de transition T tels que Li₂TO₃.

On peut aussi utiliser pour l'électrode négative un composé de lithium de même nature que l'électrode positive mais comportant une activité de lithium différente de façon à former une pile de concentration.

L'électrode négative est de préférence sous la forme d'une couche mince déposée par des procédés classiques, par exemple par évaporation sous vide ou par pulvérisation cathodique. Des couches minces obtenues par de tels procédés sont très avantageuses car le départ des ions ne crée pas de vide à l'interface.

L'électrode négative peut aussi être réalisée en alliage ou en composé comportant d'autres métaux alcalins, par exemple du sodium, du potassium, du césium ou du rubidium, ou en un composé capable de libérer des protons comme les hydrures métalliques tels que LaNi₅H₆, et les hydroxydes comme l'hydroxyde d'iridium.

Lorsque l'électrode négative est en lithium, on peut utiliser comme électrolyte solide un verre conducteur par ions lithium. Ce verre doit être un isolant électronique pour éviter l'autodécharge du générateur mais sa conductivité ionique doit être la plus élevée possible.

En effet, l'électrolyte doit jouer deux rôles essentiels : être un excellent isolant électronique entre les deux électrodes, et être un bon conducteur ionique. Son épaisseur doit être suffisante et la couche doit être rigoureusement exempte de défauts tels que des trous ou fissures, qui auraient pour conséquence immédiate une mise en court-circuit du générateur lors du dépôt de l'électrode négative.

Des verres à base d'oxyde de bore, d'oxyde de lithium et de sel de lithium peuvent être utilisés, par exemple des verres contenant en diverses proportions B₂O₃, Li₂O, et LiᵣX′ avec X′ représentant un anion capable de se combiner avec le lithium sous la forme d'un sel et r représentant la valence de l'anion X′.

A titre d'exemples d'anions X′ utilisables, on peut citer les anions halogénures et sulfate.

On pourrait aussi utiliser des verres conducteurs à base de sulfures, par exemple des verres au sulfure de bore, sulfure de lithium et sel de Lithium.

Lorsque l'électrode négative comprend d'autres métaux alcalins ou des protons, l'électrolyte peut être constitué de verres du même type contenant les mêmes ions de métal alcalin ou des protons.

L'électrolyte peut être sous la forme d'une couche réalisée par évaporation sous vide ou pulvérisation cathodique. De préférence, on utilise la pulvérisation cathodique pour obtenir une couche continue, de très faible épaisseur, sans défauts.

On peut aussi utiliser comme électrolyte des matériaux solides en polymère conducteur ionique, par exemple du type polyoxyéthylène.

La cellule électrochimique de l'invention peut être réalisée par des procédés classiques, en déposant successivement sur un substrat recouvert d'une couche conductrice de l'électricité formant collecteur de courant, une première couche de matériau amorphe, isotrope TiOₐX_{b}, une deuxième couche d'électrolyte solide et une troisième couche formant l'électrode négative.

Selon l'invention, la première couche de matériau isotrope constituant l'électrode positive est déposée par pulvérisation cathodique, de préférence par pulvérisation cathodique magnétron ; ceci permet d'obtenir une couche mince, compacte, continue et homogène, ayant un profil extrêmement régulier sans porosité superficielle.

L'épaisseur de la couche de TiOₐX_{b} peut varier dans une large gamme. Généralement, on préfère une couche mince ayant une épaisseur de 200nm à 10»m.

Cette structure est particulièrement avantageuse car l'électrolyte déposé ensuite peut être sous la forme d'une couche d'épaisseur plus faible que dans le cas des cellules électrochimiques "tout solide" de l'art antérieur.

De ce fait, même en utilisant des électrolytes ayant une conductivité ionique faible, on peut obtenir des densités de courant plus élevées que dans les cellules électrochimiques de l'art antérieur en utilisant des épaisseurs plus faibles d'électrolyte sans risque de courts-circuits.

De plus, en choisissant comme électrolyte un verre conducteur ionique, organique ou inorganique, à conductivité par ions de métal alcalin tel que le lithium, le seul élément mobile est le lithium, les anions étant bloqués dans la structure d'électrolyte. Ainsi, le transport ionique s'effectue par un seul élément et le système en couches minces facilite ce transport et permet d'obtenir des performances améliorées.

L'introduction de l'oxygène dans le matériau isotrope TiOₐX_{b} peut s'effectuer, soit avant dépôt de la couche, dans la cible utilisée pour le dépôt par pulvérisation cathodique, soit lors du dépôt en utilisant une pression partielle d'oxygène ou de vapeur d'eau très faible.

Lorsque l'oxygène est introduit dans l'atmosphère de dépôt, les pressions partielles d'oxygène ou de vapeur d'eau se situent généralement dans la gamme allant de 2.10⁻⁵ à 5.10⁻⁴hPa.

Bien que les couches isotropes de TiOₐX_{b} obtenues selon l'invention soient moins conductrices que les couches de TiS₂ cristallisé, elles ont néanmoins une conductivité suffisante pour pouvoir être utilisées dans une cellule électrochimique.

Pour la réalisation de la cellule électrochimique, la deuxième couche d'électrolyte solide et la troisième couche formant l'électrode négative peuvent être déposées par des procédés classiques convenant à la réalisation de couches minces. On peut en particulier déposer l'électrolyte solide par pulvérisation cathodique ou évaporation sous vide, et l'électrode négative par évaporation sous vide.

Les caractéristiques et avantages de l'invention apparaîtront mieux à la lecture de la description qui suit donnée bien entendu à titre illustratif et non limitatif en référence au dessin annexé sur lequel :
La figure 1 représente le spectre de diffraction X d'une couche de TiO_{1,1}S_{1,5} conforme à l'invention,
La figure 2 représente le profil de concentration obtenu par spectroscopie Auger au cours de l'érosion de la même couche de TiO_{1,1}S_{1,5},
La figure 3 représente les résultats de l'analyse de la même couche par rétrodiffusion de particules alpha,
La figure 4 représente l'évolution de la conductivité électronique en fonction de la température pour TiO_{1,1}S_{1,5} et TiS₂ cristallisé,
La figure 5 représente en coupe transverse un générateur électrochimique conforme à l'invention,
La figure 6 est un cliché de microscopie à balayage de la coupe du générateur de la figure 5,
La figure 7 est une courbe de cyclage du générateur en fonction du taux d'insertion de lithium,
La figure 8 représente une courbe de cyclage du générateur en fonction du taux d'insertion en lithium en diminuant progressivement le potentiel de décharge,
La figure 9 représente des courbes de cyclage du même générateur à différentes densités de courant,
La figure 10 représente les variations du temps de décharge pour diverses densités de courant, et
La figure 11 représente la courbe de cyclage en fonction du taux d'insertion en lithium c d'un autre générateur conforme à l'invention.

### Exemple 1.

Cet exemple illustre la réalisation d'un microgénérateur de courant comportant un substrat en verre revêtu d'un collecteur de courant en platine, d'une électrode positive en oxysulfure de titane, d'un électrolyte en verre conducteur par ions lithium et d'une électrode négative en lithium.

On part d'un substrat constitué par une plaque de verre de 7,5x2,5x0,1cm sur lequel on réalise les différentes couches de la façon suivante.

### a) Collecteur de courant en platine.

On dépose la couche de platine par pulvérisation cathodique radiofréquence en utilisant un appareil Leybold Heraeus L 560 équipé d'une pompe turbomoléculaire, et d'une cible magnétron de 75mm de diamètre avec une distance entre la cible et le substrat de 45mm et un vide limite atteint avant le dépôt de 2.10⁻⁷hPa.

Les conditions de dépôt sont les suivantes
- pression d'argon : 5.10⁻³hPa
- puissance : 50W
- tension cible : 95V
- durée : 5min.

On obtient ainsi une couche de platine de 0,2»m d'épaisseur environ.

### b) Electrode positive en TiOₐS_{b}.

Sur cette couche de platine, on dépose par pulvérisation cathodique une couche mince d'oxysulfure de titane à partir d'une cible de sulfure de titane contenant 5% en atome d'oxygène environ. Cette cible est préparée par pastillage d'une poudre de TiS₂ contenant 5% d'oxygène suivie d'un frittage à 400°C sous argon pendant 12h.

Pour réaliser la couche par pulvérisation cathodique on utilise le même appareillage que dans l'exemple 1 et on réalise le dépôt dans les conditions suivantes :
- pression d'argon : 10⁻²hPa
- puissance : 50W, soit 1,13 W/cm²
- tension cible : 100V
- durée du dépôt : 3h.

On obtient ainsi une couche d'oxysulfure de titane de couleur brun foncé à reflets métalliques, amorphe aux rayons X, sont l'épaisseur déterminée par microscopie électronique est de 1,1»m.

La structure amorphe de la couche est également confirmée par diffraction électronique.

On détermine ensuite la densité de cette couche par absorption des rayons X. On trouve ainsi une densité d'environ 2, ce qui ne représente que 64% de la densité du TiS₂ cristallisé (d=3,22) et que 50% de celle du TiO₂ cristallisé (d ≃ 4).

Ainsi, le matériau obtenu présente une densité faible qui, combinée à l'absence de cristallisation, est très favorable à l'insertion du lithium sans créer de perturbations au sein du matériau. En effet, la couche n'a pas de porosité, est compacte, continue et homogène.

On vérifie ensuite la composition du matériau obtenu par spectroscopie Auger.

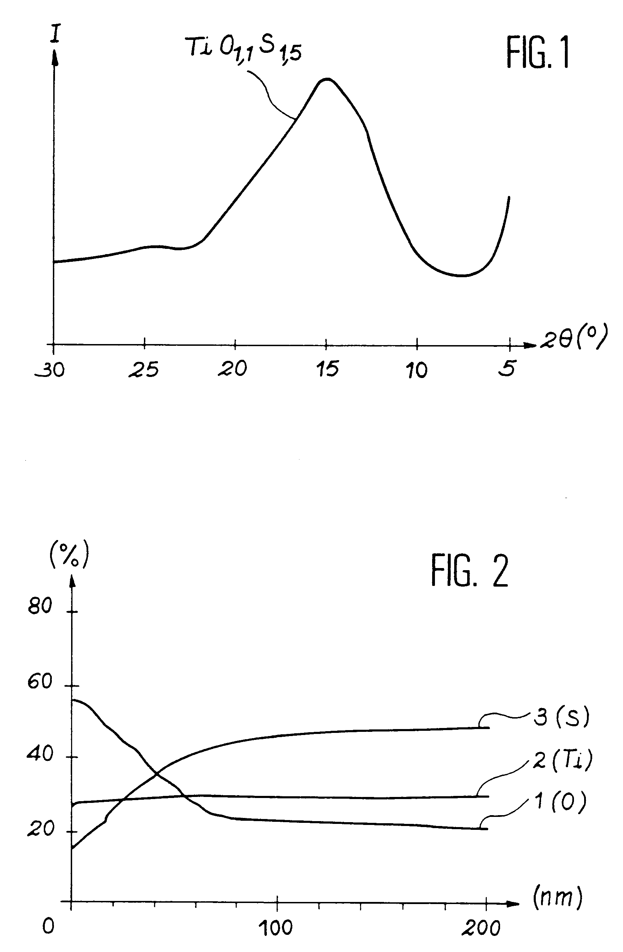

Le spectre de diffraction X est représenté sur la figure 1 et confirme l'état amorphe du matériau.

La figure 2, représente les résultats obtenus par spectrométrie Auger lors d'une érosion de la couche, c'est-à-dire les profils de concentration des éléments constitutifs en fonction de l'épaisseur (en nm) de la couche.

Sur cette figure, la courbe 1 se réfère à la concentration en oxygène, la courbe 2 se réfère à la concentration en titane et la courbe 3 se réfère à la concentration en soufre.

Sur cette figure, on constate une forte proportion d'oxygène en surface de la couche qui est vraisemblablement dûe à une hydrolyse partielle de la couche au cours des transferts en présence d'air. On note également une quantité notable d'oxygène dans toute l'épaisseur de la couche.

Pour connaître avec précision la composition de la couche, on l'analyse par la méthode RBS (Rutherford Back Scattering), c'est-à-dire par rétrodiffusion des particules alpha.

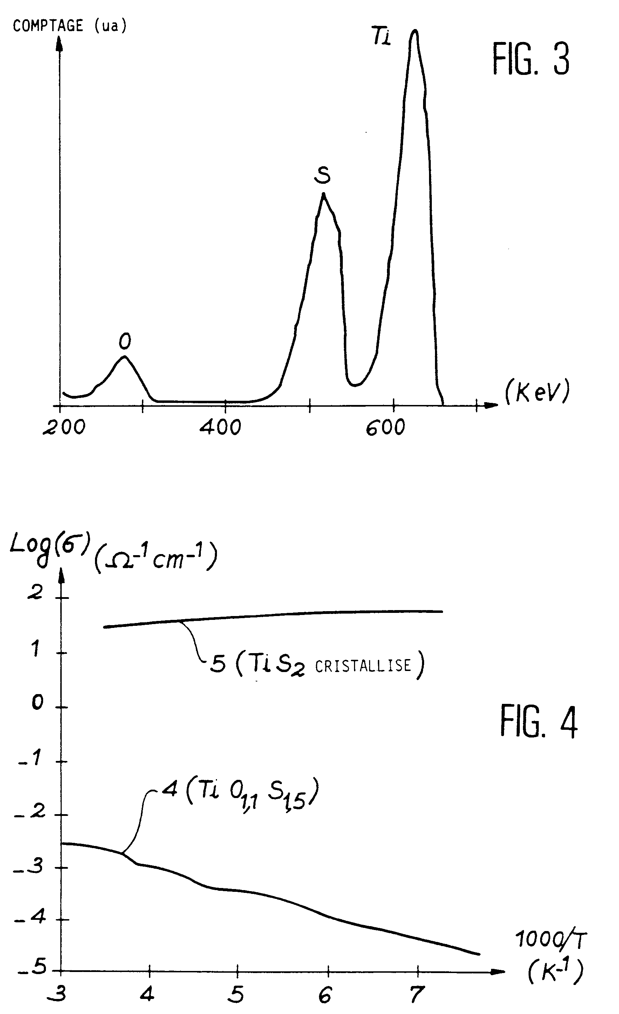

Les résultats obtenus sont représentés sur la figure 3 où l'on observe 3 pics correspondant respectivement à O,S et Ti. Par intégration des pics, on peut déduire la composition de la couche qui correspond à TiO_{1,1}S_{1,5}.

Des mesures de conductivité électronique sont aussi effectuées sur cette couche de TiO_{1,1}S_{1,5}. Les résultats obtenus sont donnés sur la figure 4 qui représente les variations de la conductivité σ en fonction de la température. Sur cette figure, la courbe 4 se réfère à TiO_{1,1}S_{1,5} alors que la courbe 5 se réfère à TiS₂.

On remarque ainsi que TiO_{1,1}S_{1,5} possède des propriétés très différentes de celles de TiS₂.

La conductivité de TiO_{1,1}S_{1,5} est de type semi-conducteur. Elle est plus faible que celle de TiS₂ qui est de type métallique. Ceci peut être dû au changement de composition ainsi qu'à l'absence de cristallisation. Cette conductivité demeure cependant satisfaisante pour un matériau d'électrode positive, elle ne doit donc pas être un facteur limitant.

### c) Dépôt de la couche d'électrolyte.

L'électrolyte utilisé est un verre de composition 1B₂O₃ - 0,8 Li₂O -0,8 Li₂SO₄.

On dépose une couche de verre de cette composition par pulvérisation cathodique en utilisant le même appareillage que précédemment et une cible de verre obtenue par pastillage d'une poudre de verre de même composition suivi d'un frittage à l'air à 600°C pendant 6h.

Les conditions de dépôt sont les suivantes :
- pression d'argon : 10⁻²hPa
- puissance : 100W, soit 2,26W/cm²
- tension cible : 250V
- durée : 4h.

On obtient ainsi une couche d'électrolyte dont l'épaisseur mesurée par microscopie électronique à balayage est de 1,8»m.

Cette couche est amorphe aux rayons X.

On détermine la conductivité ionique de cette couche par la méthode des impédances complexes.

La variation de la conductivité en fonction de la température suit la loi d'Arrhénius, sa valeur est de 1,6 10⁻⁷ Ω⁻¹cm⁻¹ à 25°C et l'énergie d'activation est de 0,6eV.

En dépit d'une conductivité relativement faible, la résistance attribuable à l'électrolyte dans le microgénérateur demeure faible.

### d) Dépôt de l'électrode négative.

L'électrode négative est réalisée en lithium et déposée par évaporation sous vide secondaire en chauffant du lithium métallique par effet Joule dans un creuset en fer. Les conditions de dépôt sont les suivantes :
- vide résiduel : 10⁻⁷hPa
- substrat refroidi à l'eau
- distance creuset-substrat : 10cm
- température du creuset : 430°C
- durée de l'évaporation : 4min.

On obtient ainsi un film de lithium dont l'épaisseur mesurée par microscopie électronique à balayage est de 15»m.

Le film de lithium réagissant avec l'azote et l'humidité de l'air, on effectue cette évaporation sous vide, puis on transfère le générateur dans une boîte à gants contenant de l'argon sec à l'aide d'un module étanche. On l'encapsule ensuite avec une résine époxy hydrophobe puis on le conserve dans un conteneur étanche.

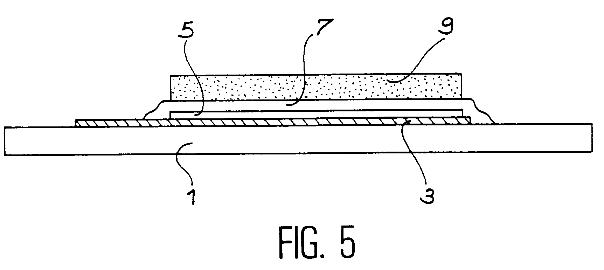

Sur la figure 5, on a représenté en coupe verticale le microgénérateur ainsi obtenu. Sur cette figure, on voit que le microgénérateur comprend un substrat (1) recouvert d'une couche (3) de collecteur de courant en platine, d'une couche (5) d'oxysulfure de titane, d'une couche (7) d'électrolyte en verre conducteur ionique et de la couche (9) de lithium constituant l'électrode négative.

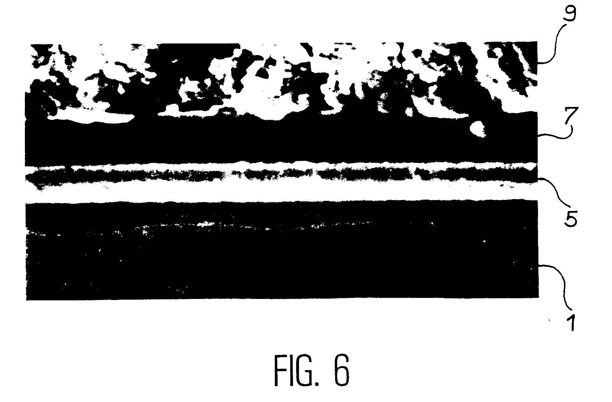

La figure 6 est un cliché de microscopie à balayage qui illustre une section du microgénérateur de la figure 5.

Sur cette micrographie, on voit le substrat (1), la couche d'oxysulfure de titane (5), la couche d'électrolyte (7) et l'électrode négative en lithium (9). On remarque que la couche d'oxysulfure de titane (5) est continue, très régulière, homogène et d'épaisseur très faible. Ceci permet en particulier d'utiliser une épaisseur d'électrolyte également faible et d'obtenir des performances améliorées en évitant tout risque de court-circuit entre les électrodes 5 et 9.

On vérifie les propriétés électrochimiques du microgénérateur en le testant galvanostatiquement sur un banc automatique de cyclage piloté par ordinateur. Les cycles sont effectués dans les conditions suivantes :
- densité de courant : 1»A/cm²
- décharge : tension de seuil minima de 1,25V
- charge : tension de seuil maxima de 2,9V
- relaxation : 2h.

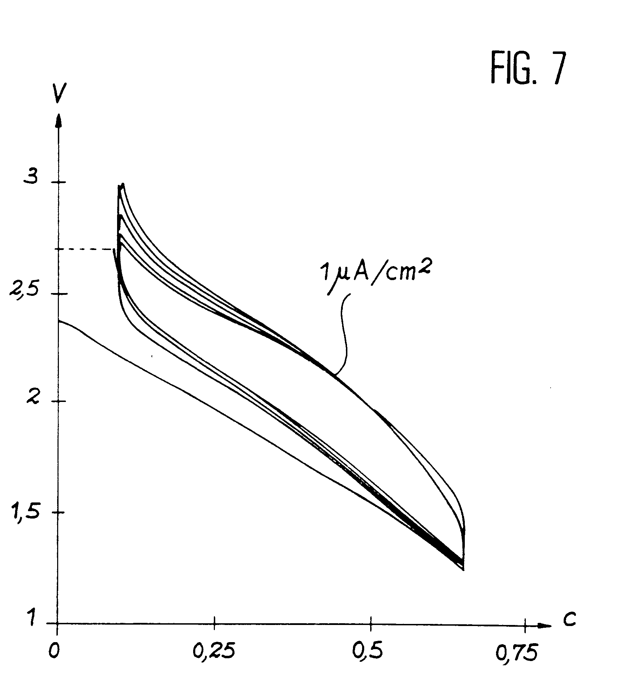

La figure 7 représente la courbe de cyclage obtenue en fonction du taux d'insertion de lithium (c) dans l'électrode positive en TiO_{1,1}S_{1,5}. Le cyclage a été réalisé pour des valeurs de c comprises entre 0,1 et 0,7. On remarque une très bonne réversibilité des cycles charge-décharge.

D'autres essais ont montré que l'on peut effectuer plus de 500 cycles avec une densité de courant de 50»A/cm² sans noter une baisse de performance au générateur. Les premiers microgénérateurs ont été construits depuis 2 ans, et l'on observe aucune baisse de leurs performances. On peut donc s'attendre à ce que la durée de vie des générateurs de l'invention excède largement 2 ans.

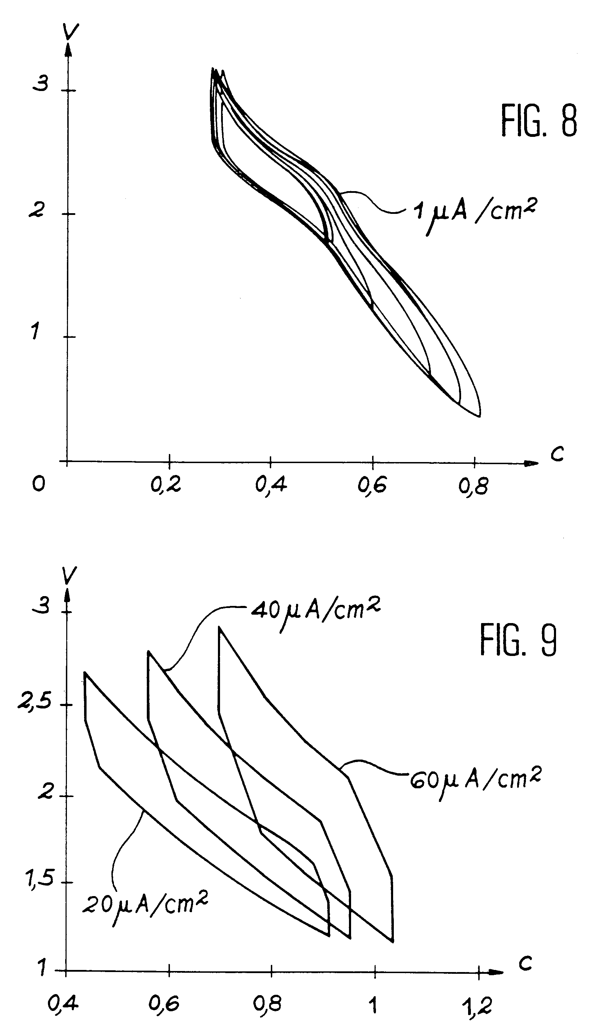

On effectue encore d'autres essais de cyclage en diminuant progressivement le seuil bas du potentiel de décharge, en opérant à une densité de courant de 1»A/cm². Les résultats obtenus sont donnés sur la figure 8.

Au vu de cette figure, on constate que ce microgénérateur peut supporter une décharge jusqu'à 0,4V et être rechargé, sans subir aucun dommage.

Ainsi, contrairement à ce que l'on obtient avec un microgénérateur à électrode positive en TiS₂ cristallisé, le système est réversible à basse tension. Ceci laisse penser que le titane n'est pas le seul élément participant à la réaction électrochimique.

On effectue d'autres essais en augmentant progressivement la densité de courant et le microgénérateur peut débiter sans problème plus de 60»A/cm², ce qui est beaucoup plus élevé qu'avec les générateurs de l'art antérieur.

On effectue également des cyclages du microgénérateur avec des densités de courant de 20»A/cm², 40»A/cm² et 60»A/cm². Les cycles s'effectuent entre un seuil haut et un seuil bas imposés. Les résultats obtenus sont donnés sur la figure 9 en fonction du taux d'insertion c du lithium. On voit que la réversibilité du système électrochimique est très bonne. La polarisation est simplement accrue en régime de charge lorsque la densité de courant augmente, très vraisemblablement en raison de la diffusion du lithium au sein du matériau.

Le microgénérateur obtenu présente une grande capacité, de l'ordre de 50»Ah/cm² pour un courant de 1»A/cm² et un seuil bas de 0,4V.

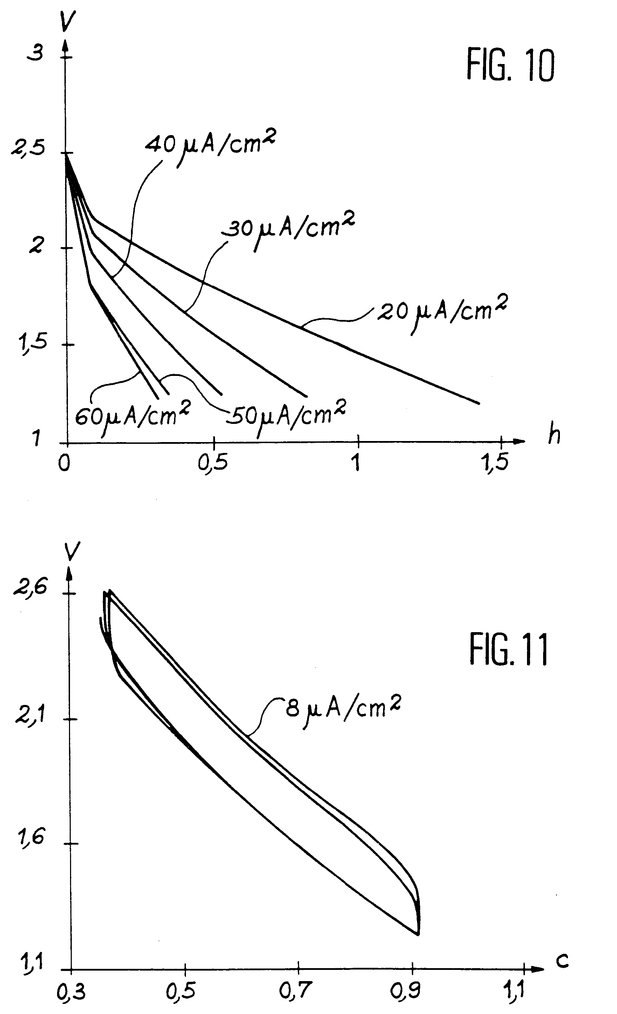

La figure 10 représente la variation du temps de décharge (en h) pour les diverses densités de courant utilisées.

On remarque ainsi que le microgénérateur de l'invention présente des propriétés électrochimiques très intéressantes, en particulier une grande capacité, la possibilité de débiter une densité de courant supérieure à 60»A/cm², ce qui est considérable par rapport aux densités de courant que l'on peut obtenir avec les générateurs de l'art antérieur, et la propriété de résister sans dommage à des cyclages répétés même à basse tension.

### Exemple 2.

Cet exemple illustre la réalisation d'une cellule électrochimique utilisable comme système électrochrome.

Dans ce cas, on utilise un collecteur de courant en oxyde mixte d'indium et d'étain comprenant 90% de In₂O₃ et 10% de SnO₂ et on dépose une couche de cet oxyde mixte par pulvérisation cathodique à partir d'une cible du même oxyde mixte, en opérant dans les conditions suivantes :
- pression d'argon : 10⁻²hPa
- puissance : 100W
- tension cible : 300V
- durée : 5min.

On obtient ainsi une couche d'oxyde mixte qui est un bon conducteur électronique et qui présente l'avantage d'être très adhérente et transparente.

On réalise ensuite l'électrode en oxysulfure de titane, l'électrolyte et l'électrode négative en lithium de la même façon que dans l'exemple 1.

La courbe de cyclage du microgénérateur ainsi obtenue fonctionnant avec une densité de courant de 8»A/cm² est donnée sur la figure 11.

L'utilisation d'un tel collecteur de courant permet de faire fonctionner la cellule comme système électrochrome. Dans ce cas, il est toutefois préférable que l'électrode positive ait une composition proche de celle de l'oxyde de titane (b proche de 0,1). En effet, cet oxysulfure à l'état pur est transparent, mais lorsque du lithium vient s'insérer dans l'électrode positive en oxyde de titane, celle-ci prend une couleur bleu foncé qui permet l'affichage.

Dans ce cas, si l'on veut utiliser la cellule comme vitrage changeant de couleur, il faut de plus associer une électrode négative transparente, par exemple en hydroxyde d'iridium avec un conducteur protonique, et utiliser des surfaces plus importantes d'électrodes.

Ainsi, le fait d'utiliser selon l'invention une couche mince en TiOₐX_{b} déposée par pulvérisation cathodique permet d'obtenir un microgénérateur "tout solide" présentant des performances améliorées, dues notamment au caractère amorphe isotrope et à la faible densité de la couche qui sont favorables à l'insertion du lithium, et à la présence d'une autre espèce (O ou S) participant à la réaction électrochimique.

L'utilisation simultanée d'un électrolyte en couche mince déposé lui aussi par pulvérisation cathodique participe également à l'obtention des bonnes caractéristiques électrochimiques, en particulier grâce à sa bonne conductivité ionique et son excellente isolation électronique et sa bonne adhérence, ce qui évite I'autodécharge du générateur.

Bien que dans ces exemples, on ait décrit des microgénérateurs à faible surface d'électrode, il va de soi que l'invention s'applique également à des générateurs de grande surface d'électrode présentant une puissance non négligeable.

Pour la réalisation de tels générateurs, on peut envisager d'utiliser un substrat isolant souple que l'on fait défiler dans la ou les enceintes de dépôt pour le revêtir successivement des différentes couches.

Pour l'utilisation, on peut si on le désire le présenter sous la forme d'un enroulement en spires à condition bien entendu qu'il y ait entre celles-ci un film isolant constitué soit par le substrat, soit par un film additionnel.

## Revendications

1. Elément composite constitué par un substrat revêtu par pulvérisation cathodique d'une couche mince, compacte, continue et homogène de matériau amorphe aux rayons X et isotrope répondant à la formule :
TiOₐX_{b}.
dans laquelle X représente un atome de soufre, de sélénium ou de tellure, et
a et b sont tels que
0,01≦a≦2
0,01≦b≦3
2≦a+b≦3,
ladite couche ayant une épaisseur de 200nm à 10»m, une structure amorphe expansée et ur profil extrêmement régulier sans porosité superficielle.

2. Elément selon la revendication 1, caractérisé en ce que X représente un atome de soufre.

3. Elément composite selon l'une quelconque des revendications 1 et 2 à 3, caractérisé en ce que le substrat est en matériau isolant recouvert d'une couche de matériau conducteur de l'électricité sur laquelle est déposée la couche de matériau TiOₐX_{b}.

4. Cellule électrochimique comportant une électrode positive, une électrode négative capable de libérer un proton ou un ion de métal alcalin et un électrolyte conducteur ionique disposé entre les deux électrodes, caractérisé en ce que l'électrode positive est formée d'une couche mince, composite, continue et homogène de matériau amorphe aux rayons X et isotrope, déposée par pulvérisation cathodique, répondant à la formule :
TiOₐX_{b}
dans laquelle X représente S, Se ou Te, et a, b sont tels que
0,01≦a≦2
0.01≦b≦3
2≦a+b≦3
ladite couche ayant une épaisseur de 200nm à 10»m, une structure amorphe expansée et un profil extrêmement régulier sans porosité superficielle.

5. Cellule électrochimique selon la revendications 4, caractérisée en ce que X représente S.

6. Cellule selon l'une quelconque des revendications 4 et 5, caractérisée en ce que l'électrode négative est en lithium.

7. Cellule électrochimique selon la revendication 6, caractérisée en ce que l'électrolyte est un verre conducteur par ions lithium.

8. Cellule électrochimique selon la revendication 7, caractérisée en ce que le verre conducteur ionique contient en proportions variables B₂O₃, Li₂O, LiᵣX′ avec X′ représentant un anion de valence r.

9. Cellule électrochimique selon l'une quelconque des revendications 4 à 8, caractérisée en ce que l'électrode positive est déposée sur un substrat comportant une couche conductrice formant collecteur de courant.

10. Cellule électrochimique selon la revendication 9, caractérisée en ce que le collecteur de courant est en platine.

11. Cellule électrochimique selon la revendication 9, caractérisée en ce que le collecteur de courant est en verre conducteur transparent.

## Claims

1. Composite element constituted by a substrate coated by cathodic sputtering with an isotropic, amorphous material coating in accordance with the formula:
TiOₐX_{b}
in which X represents a sulphur, selenium or tellurium atom and a and b are such that 0.01 ≦ a ≦ 2, 0.01 ≦ b ≦ 3 and 2 ≦ a+b ≦ 3, said coating having a thickness of 200 nm to 10 »m, an expanded amorphous structure and an extremely regular profile without surface porosity.

2. Element according to claim 1, oharacterized in that X represents a sulphur atom.

3. Composite element according to either of the claims 1 and 2, characterized in that the substrate is an insulating material covered with an electricity conducting material coating on which is deposited the TiOₐX_{b} material coating.

4. Electrochemical cell having a positive electrode, a negative electrode able to release a proton or an alkali metal ion and an ionic conductive electrolyte located between the two electrodes, characterized in that the positive electrode is formed by an isotropic, amorphous material coating, deposited by cathodic sputtering and in accordance with the formula:
TiOₐX_{b}
in which X represents S, Se or Te, and a and b are such that 0.01 ≦ a ≦ 2, 0.01 ≦ b ≦ 3 and 2 ≦ a+b ≦ 3, said coating having a thickness of 200 nm to 10 »m, an expanded amorphous structure andan extremely regular profile without surface porosity.

5. Electrochemical cell according to claim 4, characterized in that X represents S.

6. Cell according to either of the claims 4 and 5, characterized in that the negative electrode is of lithium.

7. Electrochemical cell according to claim 6, characterized in that the electrolyte is lithium ion-conductive glass.

8. Electrochemical cell according to claim 7, characterized in that the ionic conductive glass contains in variable proportions B₂O₃, Li₂O, Li₄X′ with X′ representing an anion of valency r.

9. Electrochemical cell according to any one of the claims 4 to 8, characterized in that the positive electrode is deposited on a substrate having a conductive coating forming a current collector.

10. Electrochemical cell according to claim 9, characterized in that the current collector is of platinum.

11. Electrochemical cell according to claim 9, characterized in that the current collector is of transparent conductive glass.

## Patentansprüche

1. Verbundelement, bestehend aus einem Substrat, das durch Kathodenzerstäubung mit einer dünnen, festen, zusammenhängenden und homogenen Schicht eines gegenüber Röntgenstrahlen amorphen und isotropen Stoffes überzogen ist, der der Formel
TiOₐX_{b}
entspricht, worin X für ein Schwefel-, Selen- oder Telluratom steht und a und b derart sind, daß
0,01 ≦ a ≦ 2
0,01 ≦ b ≦ 3
2 ≦ a + b ≦ 3,
wobei genannte Schicht eine Dicke von 200 nm bis 10 »m, eine expandierte amorphe Struktur und ein außerst regelmäßiges Profil ohne oberflächliche Porosität besitzt.

2. Element nach Anspruch 1, dadurch gekennzeichnet, daß X für ein Schwefelatom steht.

3. Verbundelement nach einem der Ansprüche 1 und 2, dadurch gekennzeichnet, daß das Substrat aus isolierendem Material besteht, welches mit einer Schicht von elektrisch leitendem Material bedeckt ist, auf der die Schicht des Stoffes TiOₐX_{b} abgeschieden ist.

4. Elektrochemische Zelle, umfassend eine positive Elektrode, eine negative Elektrode, die fähig ist, ein Proton oder ein Alkalimetallion abzugeben, und einen ionenleitenden Elektrolyten, der zwischen den zwei Elektroden angeordnet ist, dadurch gekennzeichnet, daß die positive Elektrode aus einer dünnen, verbundenen, zusammenhängenden und homogenen, durch Kathodenzerstäubung abgeschiedenen Schicht eines gegenüber Röntgenstrahlen amorphen und isotropen Stoffes entsprechend der Formel
TiOₐX_{b}
besteht, worin X für S, Se oder Te steht und a, b derart sind, daß
0,01 ≦ a ≦ 2
0,01 ≦ b ≦ 3
2 ≦ a + b ≦ 3,
wobei genannte Schicht eine Dicke von 200 nm bis 10 »m, eine expandierte amorphe Struktur und ein äußerst regelmäßiges Profil ohne oberflächliche Porosität besitzt.

5. Elektrochemische Zelle nach Anspruch 4, dadurch gekennzeichnet, daß X für S steht.

6. Zelle nach einem der Ansprüche 4 und 5, dadurch gekennzeichnet, daß die negative Elektrode aus Lithium ist.

7. Elektrochemische Zelle nach Anspruch 6, dadurch gekennzeichnet, daß der Elektrolyt aus Glas besteht, welches durch Lithiumionen leitend ist.

8. Elektrochemische Zelle nach Anspruch 7, dadurch gekennzeichnet, daß das ionenleitende Glas in veränderlichen Anteilen B₂O₃, Li₂O, LiᵣX′ enthält, worin X′ für ein Anion der Wertigkeit r steht.

9. Elektrochemische Zelle nach einem der Ansprüche 4 bis 8, dadurch gekennzeichnet, daß die positive Elektrode auf einem Substrat abgeschieden ist, welches eine leitende Schicht enthält, die einen Stromsammler bildet.

10. Elektrochemische Zelle nach Anspruch 9, dadurch gekennzeichnet, daß der Stromsammler aus Platin ist.

11. Elektrochemische Zelle nach Anspruch 9, dadurch gekennzeichnet, daß der Stromsammler aus transparentem leitendem Glas besteht.
